# EUROPÄISCHE PATENTSCHRIFT

(11) **EP 1 543 619 B1**
(45) Veröffentlichungstag und Bekanntmachung des Hinweises auf die Patenterteilung: **11.04.2012**
(21) Anmeldenummer: 03770890.6
(22) Anmeldetag: 26.09.2003
(51) Int. Cl.: H03K 21/12

(54) **UNTERBRECHUNGSFREI AUSLESBARER DIGITALER ZÄHLER SOWIE VERFAHREN ZUM ZÄHLEN VON ZAHLIMPULSEN**
DIGITAL COUNTER THAT CAN BE READ OUT WITHOUT INTERRUPTING THE PROCESS AND METHOD FOR COUNTING COUNTER PULSES
COMPTEUR NUMERIQUE POUVANT ETRE LU SANS SUBIR D'INTERRUPTIONS ET PROCEDE DE COMPTAGE D'IMPULSIONS DE COMPTAGE

(30) Priorität: 27.09.2002 DE 10245126
(43) Veröffentlichungstag der Anmeldung: 22.06.2005
(73) Patentinhaber: Fraunhofer-Gesellschaft zur Förderung der angewandten Forschung e.V., 80686 München (DE)
(72) Erfinder: MICHEL, Norbert, 91220 Schnaittach (DE)
(74) Vertreter: Gagel, Roland
(86) Internationale Anmeldenummer: PCT/DE2003/003217
(87) Internationale Veröffentlichungsnummer: WO 2004/032325

(56) Entgegenhaltungen:
- DE-A- 10 012 337
- US-A- 3 982 108
- US-A- 4 160 154

## Beschreibung

### Technisches Anwendungsgebiet

Die vorliegende Erfindung betrifft einen digitalen Zähler, der eine digitale erste Zähleinrichtung und eine Ausleseeinrichtung zum Auslesen eines Zählerstandes der ersten Zähleinrichtung sowie zum Unterbrechen einer Zählbereitschaft der ersten Zähleinrichtung oder zum Sperren des Zugangs von Zählimpulsen zur ersten Zähleinrichtung während eines Auslesevorganges aufweist. Die Erfindung betrifft weiterhin ein Verfahren zum Zählen von Zählimpulsen, bei dem die Zählimpulse mit einem digitalen Zähler erfasst werden und bei dem während eines Auslesevorganges des Zählers die Zählbereitschaft der ersten Zähleinrichtung unterbrochen oder der Zugang der Zählimpulse zur ersten Zähleinrichtung gesperrt wird.

Digitale Zähler werden in vielen technischen Bereichen eingesetzt und sind wichtige Bestandteile aller digital arbeitenden Mess-, Steuer-, Regel- und Rechenanlagen. Sie sind in vielen Fällen als Kettenschaltungen von Flip-Flops realisiert und zur direkten Erfassung von Frequenzen bis weit über 10 GHz geeignet. Ein besonderes Problem bei der Realisierung und dem Betrieb digitaler Zähler stellt der Auslesevorgang dar. Wenn ein digitaler Zähler seinen Wert aufgrund eines eingegangenen Zählimpulses verändert, ist der Zähler für die Zeitdauer, innerhalb der die Veränderung stattfindet, in einem metastabilen Zustand. Die Zeitdauer für die Änderung des Zählerstandes hängt von der Schaltgeschwindigkeit der im Zähler eingesetzten Bauteile ab und ist häufig von Exemplar zu Exemplar mit großen Toleranzen behaftet. Wird der Zähler während einer Veränderung des Zählerstandes ausgelesen, so kann der ausgelesene Wert aufgrund des metastabilen Zustandes falsch sein. Dieser Fehler kann gerade bei digitalen Zählern erheblich sein, da sich bei einer Änderung des Zählerstandes um 1 auch höherwertige Bits verändern und somit falsch ausgelesen werden können.

### Stand der Technik

Zur Vermeidung dieser Problematik beim Auslesen digitaler Zähler ist es bekannt, die Auslesevorgänge auf Zeiträume zu begrenzen, innerhalb derer sich der Zählerstand mit Sicherheit nicht verändert. So beschreibt die US 4,881,248 A einen digitalen Zähler mit einer digitalen Zähleinrichtung, einer Ausleseeinrichtung sowie einer Steuereinrichtung, die eine während der Zeitdauer einer Änderung des Zählerstandes eintreffende Ausleseanforderung verzögert, bis ein stabiler Zählerzustand erreicht ist. Auf diese Weise lässt sich der Zähler asynchron auslesen, ohne die Zählbereitschaft zu unterbrechen. Die dargestellte Lösung setzt jedoch voraus, dass einerseits die kürzeste Wiederholrate der Zählimpulse bekannt ist und andererseits ein verzögertes Auslesen durch die entsprechende Anwendung toleriert werden kann.

Eine weitere Möglichkeit zum korrekten Auslesen eines digitalen Zählers besteht darin, den Zähler für den Zeitraum des Auslesens am Weiterzählen zu hindern. Durch diese Maßnahme weist der digitale Zähler jedoch Totzeiten auf, während derer eintreffende Zählimpulse nicht registriert werden. Dies führt gerade bei unregelmäßig eintreffenden Zählimpulsen zu Fehlern.

Aus der US 5,045,854 A ist ein synchroner Zähler bekannt, bei dem eine Zähleinrichtung eingesetzt wird, die auf Basis eines Gray-Codes zählt. Der ausgelesene Gray-Code wird anschließend in einen Digitalwert umgewandelt. Durch das Zählen im Gray-Code wird der maximale Fehler, der durch das Auslesen des Zählers während einer Veränderung des Zählerstandes auftreten kann, auf ein Bit reduziert. Eine zeitliche Abstimmung zwischen Auslesevorgang und Änderung des Zählerstandes oder ein Sperren des Zählers während des Auslesevorganges sind bei Tolerierung dieses maximalen Fehlers nicht erforderlich.

Die JP 06314968 A schlägt einen Zähler sowie ein Verfahren zum Auslesen des Zählers vor, bei dem die Ausleseeinrichtung zum Auslesen des Zählerstandes den Zähler stoppt, damit dieser fehlerfrei ausgelesen werden kann. Während dieser Totzeit des Zählers eintreffende Zählimpulse werden auf einen Zwischenzähler umgeleitet, über den der Hauptzähler im Anschluss an den Auslesevorgang mit der im Zwischenzähler gespeicherten Anzahl von Zählimpulsen nachgetaktet wird. Der in dieser Druckschrift vorgeschlagene Zähler sowie das zugehörige Verfahren bergen jedoch die Unsicherheit, dass ein Zählimpuls, der gerade zum Zeitpunkt des Sperrens des Hauptzählers und des Umleitens auf den Zwischenzähler auftritt, gar nicht, gerade noch richtig oder doppelt gezählt wird.

Die Einschränkungen der Zähler bzw. Verfahren des vorgenannten Standes der Technik sind für viele Anwendungen nicht tolerierbar. Beispielsweise kann die Ausleseanforderung bei einem Ereigniszähler mit sehr unterschiedlicher und nicht vorhersagbarer Zeit zwischen zwei Ereignissen nicht beliebig verzögert werden, z.B. bis kurz nach dem nächsten Ereignis. Wird die Zählbereitschaft für die Dauer des Auslesens unterbrochen, so kann gerade in diesem Moment ein vielleicht seltenes Ereignis unregistriert bleiben.

Aus der DE 10012337A1 ist eine digitale Schaltungsanordnung zum kontinuierlichen Zählen von Impulsen ohne Totzeit bekannt, die ein fehlerfreies asynchrones Auslesen des Zählers ermöglicht. Die dort dargestellte Schaltung besteht aus zwei Zähleinrichtungen, wobei während eines Auslesevorgangs die Zählbereitschaft der einen Zähleinrichtung unterbrochen ist und die Zählbereitschaft durch die zweite digitale Zähleinrichtung sicher gestellt wird. Weiterhin kann eine Korrektur des Zählerstandes der Zähleinrichtung durch Einschreiben eines Vorgabewertes in die Zähleinrichtung durchgeführt werden.

Aus der JP 07264050A ist ein digitaler Zähler bekannt, bei dem ein zeitgleiches Ereigniszählen und Auslesen des Zählerstandes erfolgen kann. Hierbei liegt ein zu zählendes Signal gleichzeitig am Eingang von zwei Zähleinrichtungen an, wobei der Zählerstand aus der einen Zähleinrichtung ausgelesen wird, während die andere Zähleinrichtung kontinuierlich weiter zählt. Der Zähler umfasst auch eine Vergleichs- und Korrektureinheit, durch die nach Auslesen des Zählerstandes des einen Zählers dieser mit einem Unterschiedswert, der aus einem Vergleich der beiden Zählerstände ermittelt wird, korrigiert wird.

Aus der EP 0133735A2 ist ein weiterer digitaler Zähler bekannt, der ein Auslesen des Zählerstandes ohne Unterbrechung des Zählvorganges ermöglicht. In dieser Druckschrift wird darauf hingewiesen, dass es zur Vermeidung von Totzeiten während des Zählvorganges bekannt ist, zwei Zähleinrichtungen einzusetzen, wobei eine Zähleinrichtung weiter zählt während die andere ausgelesen wird.

Die US 4,160,154 A beschreibt eine Einrichtung zur Zeitmessung, mit der der zeitliche Abstand zwischen zwei Ereignissen gemessen werden soll. Die Einrichtung umfasst u. a. einen digitalen Zähler, der eine digitale erste Zähleinrichtung mit einem ersten Zählersegment für ein oder mehrere niederwertigste Bits, eine Ausleseeinrichtung zum Auslesen des Zählerstandes der ersten Zähleinrichtung sowie zum Unterbrechen der Zählbereitschaft der ersten Zähleinrichtung während des Auslesevorgangs sowie eine digitale zweite Zähleinrichtung mit einem zweiten Zählersegment für eine gleiche Anzahl von Bits wie das erste Zählersegment umfasst, die zur gleichzeitigen Erfassung der Zählimpulse parallel zur ersten Zähleinrichtung angeordnet ist. Weiterhin ist eine Vergleichseinrichtung zum Vergleich der Zählersegmenstände des ersten und des zweiten Zählersegmentes nach dem Auslesevorgang und zur Fortsetzung des Zählens der ersten Zähleinrichtung bei Gleichheit der Zählersegmentstände des ersten und des zweiten Zählersegmentes vorgesehen.

Die US 6,075,833A offenbart eine auf Basis eines Gray-Codes zählende Zählerschaltung mit zwei parallel geschalteten Zählsegmenten.

Ausgehend von diesem Stand der Technik besteht die Aufgabe der vorliegenden Erfindung darin, einen digitalen Zähler sowie ein Verfahren zum Zählen von Zählimpulsen anzugeben, die ein fehlerfreies asynchrones Auslesen des Zählers ermöglichen.

### Darstellung der Erfindung

Die Aufgabe wird mit dem digitalen Zähler gemäß Patentanspruch 1 sowie dem Zählverfahren gemäß Patentanspruch 9 gelöst. Vorteilhafte Ausgestaltungen des digitalen Zählers sind Gegenstand der Unteransprüche oder lassen sich aus der nachfolgenden Beschreibung und den Ausführungsbeispielen entnehmen.

Der vorliegende digitale Zähler mit einer digitalen ersten Zähleinrichtung mit einem ersten Zählersegment für ein oder mehrere niederwertigste Bits und einer Ausleseeinrichtung zum Auslesen eines Zählerstandes der ersten Zähleinrichtung sowie zum Unterbrechen einer Zählbereitschaft der Zähleinrichtung oder zum Sperren des Zugangs von Zählimpulsen zur ersten Zähleinrichtung während eines Auslesevorgangs weist eine digitale zweite Zähleinrichtung mit einem zweiten Zählersegment für die gleiche Anzahl von Bits wie das erste Zählersegment auf, die zur gleichzeitigen Erfassung der Zählimpulse parallel zur ersten Zähleinrichtung angeordnet ist, sowie eine Vergleichs- und Korrektureinrichtung zum Vergleich der Zählersegmentstände des ersten und zweiten Zählersegmentes nach dem Auslesevorgang und zur Korrektur des Zählerstandes der ersten Zähleinrichtung bei einer Abweichung der Zählersegmentstände entsprechend dem vorliegenden Unterschiedswert.

Bei dem vorgeschlagenen Verfahren zum Zählen von Zählimpulsen werden die Zählimpulse mit einem digitalen Zähler erfasst, der eine digitale erste Zähleinrichtung mit einem ersten Zählersegment für ein oder mehrere niederwertigste Bits umfasst, und während eines Auslesevorganges des Zählers die Zählbereitschaft der ersten Zähleinrichtung unterbrochen oder der Zugang der Zählimpulse zur ersten Zähleinrichtung gesperrt. Das Verfahren zeichnet sich dadurch aus, dass die Zählimpulse gleichzeitig mit einer digitalen zweiten Zähleinrichtung erfasst werden, die ein zweites Zählersegment für die gleiche Anzahl von Bits wie das erste Zählersegment umfasst, nach dem Auslesevorgang die Zählersegmentstände des ersten und zweiten Zählersegments verglichen werden und bei einer Abweichung der Zählerstand der ersten Zähleinrichtung entsprechend dem Unterschiedswert der Zählersegmentstände korrigiert wird.

Unter einem Zählersegment ist hierbei ein Teil einer Zähleinrichtung zu verstehen, der ein oder mehrere aufeinander folgende Bits der gesamten digitalen Zähleinrichtung umfasst. Beim vorliegenden digitalen Zähler umfasst das erste Zählersegment die niederwertigsten Bits der ersten Zähleinrichtung. Selbstverständlich umfasst die erste Zähleinrichtung auch ein oder mehrere weitere Zählersegmente für die verbleibenden höherwertigen Bits.

Bei dem vorliegenden digitalen Zähler und dem zugehörigen Zählverfahren wird der Teil des digitalen Zählers für das oder die niederwertigsten Bits doppelt ausgelegt. Die eintreffenden Zählimpulse gelangen dabei zumindest annähernd gleichzeitig auf die beiden im Normalbetrieb parallel arbeitenden Zählersegmente der ersten und zweiten Zähleinrichtung, im Folgenden auch als Haupt- und Referenzzähler bezeichnet. Beide parallel ausgebildeten Zählersegmente müssen dabei selbstverständlich vom gleichen Urzustand aus starten. Dies kann beispielsweise durch einen gemeinsamen Reset realisiert werden. Bei Eintreffen einer Ausleseanforderung wird der Zugang der Zählimpulse zum Hauptzähler gesperrt, so dass der Zählerstand sicher ausgelesen werden kann. Das Auslesen kann beispielsweise in bekannter Weise in ein paralleles Register erfolgen. Treten während dieser Sperr- bzw. Totzeit Zählimpulse auf, so werden diese im Referenzzähler ausgehend von letzten gemeinsamen Zustand beider Zählersegmente weitergezählt. Nach Abschluss des Auslesevorganges schaltet die Ausleseeinrichtung den Hauptzähler wieder frei, so dass dieser für Zählimpulse wieder zugänglich ist. Zur gleichen Zeit werden durch die Vergleichs- und Korrektureinrichtung jeweils die parallelen Bits beider Zählersegmente verglichen. Bei einer Abweichung der Werte wird der Hauptzähler um die entsprechende Differenz nachgezählt bzw. erhöht, so dass die beiden parallelen Zählersegmente wieder die gleichen Werte aufweisen.

Die Anzahl der Bits des ersten und zweiten Zählersegmentes ist von der jeweiligen Anwendung abhängig, insbesondere von der Relation zwischen kürzester Zählimpulsfolge der Anwendung und Dauer des Auslesevorganges. Kann während der Zeitdauer des Auslesevorganges maximal ein Zählimpuls eintreffen, so reicht es aus, das zweite Zählersegment als 1 Bit-Zähler auszugestalten. In der Praxis werden Zählersegmente mit ein oder zwei Bit den Anforderungen in den meisten Fällen gerecht werden. Selbstverständlich lassen sich die doppelt ausgelegten Zählersegmente jedoch auch mit einer größeren Anzahl von Bits realisieren, die im ersten und zweiten Zählersegment jeweils den niederwertigsten Bits der ersten Zähleinrichtung entsprechen.

Mit der vorliegenden Erfindung werden ein digitaler Zähler sowie ein Zählverfahren bereit gestellt, bei denen der digitale Zähler asynchron ausgelesen werden kann, ohne dabei die Zählbereitschaft auch nur für kurze Zeit unterbrechen zu müssen. Die Ausleseanforderung kann dabei auch gleichzeitig mit Zählimpulsen auftreten. Die Zählimpulse werden dennoch gezählt bzw. registriert. Der vorliegende digitale Zähler arbeitet selbstkorrigierend. Wenn beispielsweise die Ausleseanforderung zufällig zeitgleich mit einem Zählimpuls auftritt, so spielt es keine Rolle, ob der Hauptzähler diesen Zählimpuls noch registriert oder nicht, da der Referenzzähler den Zählimpuls in jedem Falle erfasst. Die Vergleichs- und Korrektureinrichtung erkennt anschließend, ob eine Differenz zwischen den betrachteten Zählersegmenten des Haupt- und Referenzzählers vorliegt und korrigiert nach Abschluss des Auslesevorganges den Hauptzähler, bis dieser wieder synchron mit dem Referenzzähler ist. Die Zählimpulse können hierbei völlig asynchron und stochastisch auftreten. Der digitale Zähler sowie das zugehörige Zählverfahren lassen sich insbesondere bei Anwendungen sehr vorteilhaft einsetzen, bei denen unregelmäßig, eventuell auch selten auftretende Ereignisse lückenlos erfasst werden müssen, insbesondere auch im Moment des Auslesens, wie beispielsweise in der Sensorik und Messtechnik.

Vorzugsweise wird der digitale Zähler als integrierte Schaltung derart ausgeführt, dass Laufzeiten der Zählimpulse zum ersten und zweiten Zählersegment zumindest annähernd gleich sind. Bei der Realisierung als integrierte Halbleiterschaltung gelingt eine quasi identische Ausführung von Haupt- und Referenzzähler sehr gut. Selbstverständlich lässt sich der vorliegende digitale Zähler jedoch auch in elektromechanischen, mechanischen oder anderen technischen Ausführungen, beispielsweise als pneumatischer Zähler in Schaltanlagen, realisieren.

### Kurze Beschreibung der Zeichnungen

Der vorliegende digitale Zähler sowie das zugehörige Zählverfahren werden nachfolgend anhand von Ausführungsbeispielen in Verbindung mit den Zeichnungen nochmals kurz erläutert. Hierbei zeigen:
- Fig. 1: den prinzipiellen Aufbau des vorliegenden digitalen Zählers;
- Fig. 2: ein Beispiel für den vorliegenden digitalen Zähler mit einem 1 Bit-Referenzzähler;
- Fig. 3: ein Beispiel für eine monolithisch integrierte Schaltung mit einem 1 Bit-Referenzzähler; und
- Fig. 4: ausschnittsweise ein weiteres Beispiel für eine eine monolithisch integrierte Schaltung mit einem 2 Bit-Referenzzähler.

### Wege zur Ausführung der Erfindung

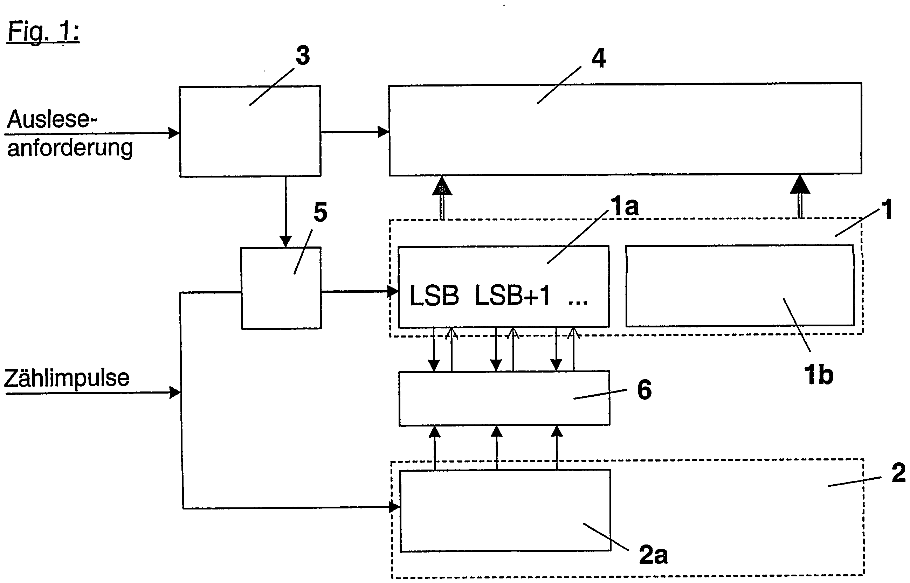

Fig. 1 zeigt den prinzipiellen Aufbau des vorliegenden digitalen Zählers. Der digitale Zähler besteht in bekannter Weise aus einer Zähleinrichtung, dem Hauptzähler 1, und einer Ausleseeinrichtung 3, 4, 5, die auf eine Ausleseanforderung hin den Zählerstand des Hauptzählers 1 in ein Leseregister 4 ausliest. Beim vorliegenden digitalen Zähler wird der Zugang von Zählimpulsen zum Hauptzähler 1 durch ein Tor 5 gesperrt, während der Auslesevorgang durchgeführt wird. Der vorliegende digitale Zähler umfasst weiterhin einen Referenzzähler 2, der zumindest ein Zählersegment 2a mit einer Anzahl von Bits aufweist, die der Anzahl der niederwertigsten Bits LSB, LSB+1, ... des Hauptzählers 1 entsprechen, die in dieser Darstellung als erstes Zählersegment 1a des Hauptzählers 1 dargestellt sind. Die Anzahl der niederwertigsten Bits dieses ersten Zählersegmentes 1a bzw. der Umfang dieses Zählersegmentes 1a des Hauptzählers 1 wird je nach Anwendung derart gewählt, dass die Anzahl von während eines Auslesevorgangs möglicherweise eintreffenden Zählimpulsen mit dieser Anzahl von Bits erfasst werden kann. Die verbleibenden höherwertigen Bits des Hauptzählers sind in der vorliegenden Darstellung als weiteres Zählersegment 1b zusammengefasst. Selbstverständlich können diese Zählersegmente, die lediglich einer vorwählbaren Einteilung des Zählers entsprechen, aus mehreren Bauteilen, wie beispielsweise Flip-Flop-Kaskaden, gebildet sein.

Der Referenzzähler 2 sowie der Hauptzähler 1 werden beim vorliegenden digitalen Zähler parallel betrieben, wie dies aus der Figur ersichtlich ist. Der Referenzzähler 2 zählt dabei alle eintreffenden Zählimpulse, während der Hauptzähler 1 während der Auslesevorgänge für die eintreffenden Zählimpulse gesperrt ist. Nach jedem Auslesevorgang werden die beiden Zählersegmente 1a und 2a durch eine Vergleichs- und Korrektureinrichtung 6 hinsichtlich ihrer identischen Anzahl von Bits verglichen. Bei einer Abweichung wird der Hauptzähler 1 entsprechend dem sich ergebenden Differenzwert korrigiert, so dass die beiden Zählersegmente 1a und 2a anschließend wieder die gleichen Bitwerte aufweisen. Auf diese Weise wird sichergestellt, dass alle eintreffenden Zählimpulse letztendlich durch den Hauptzähler 1 erfasst werden. Hierbei ist es unerheblich, ob ein zum Zeitpunkt des Sperrens des Hauptzählers 1 eintreffender Zählimpuls noch von diesem erfasst wird oder nicht, da durch die Vergleichs- und Korrektureinrichtung 6 nur bei einer Differenz der Zählersegmentstände der beiden Zählersegmente 1a und 2a eine Korrektur des Hauptzählers 1 erfolgt.

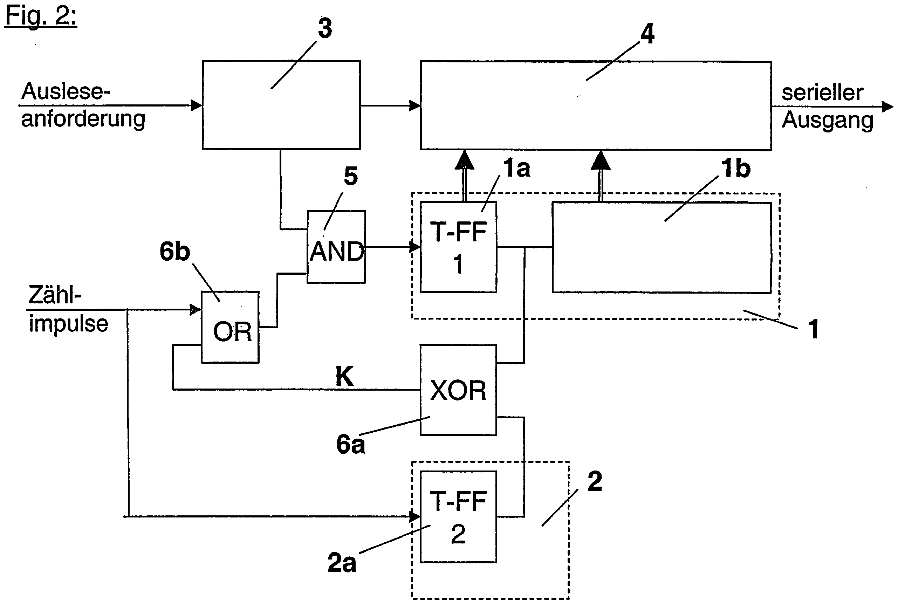

Die Größe der Zählersegmente 1a und 2a, d.h. die von diesen Zählersegmenten umfasste Anzahl von Bits, wird je nach Anwendung gewählt. Fig. 2 zeigt ein Beispiel, bei dem diese Zählersegmente jeweils nur 1 Bit umfassen, so dass sie als einzelne T-Flip-Flops (T-FF) realisiert sein können, wie dies in der Figur schematisch dargestellt ist. Das Tor 5 der Ausleseeinrichtung wird in diesem Beispiel als AND-Glied, die Vergleichs- und Korrektureinrichtung 6 als Kombination eines XOR- und eines OR-Gliedes realisiert.

Im Fall einer Ausleseanforderung sperrt die Lesesteuerung 3 der Ausleseeinrichtung das Tor 5. Der Hauptzähler 1 erhält keine Zählimpulse mehr und kann fehlerfrei parallel ins Schieberegister 4 ausgelesen werden. Sollte zeitgleich im Moment des Sperrens oder während des Auslesens ein Zählimpuls auftreten, so wird auf jeden Fall das T-Flip-Flop (zweites Zählersegment 2a) des Referenzzählers 2 getaktet, das T-Flip-Flop (erstes Zählersegment 1a) des Hauptzählers 1 jedoch möglicherweise nicht mehr. Wegen des Unterschieds an den beiden T-Flip-Flops setzt der Komparator 6a (hier XOR) das Signal auf der Signalleitung K auf High. Sobald die Lesesteuerung 3 das Tor 5 freigibt, wird durch das High auf der Signalleitung K das T-Flip-Flop des Hauptzählers 1 nachgetaktet. Dies erfolgt über das OR-Glied 6b der Vergleichs- und Korrektureinrichtung 6.

Bei dieser beispielhaften Ausgestaltung des vorliegenden digitalen Zählers muss die kürzeste Zählimpulsfolge länger sein als der komplette Lesevorgang. Weiterhin muss die Dauer eines Zählimpulses deutlich kürzer als der komplette Lesevorgang sein. Die letztere Bedingung kann durch Vorschalten eines Differenzgliedes erfüllt werden.

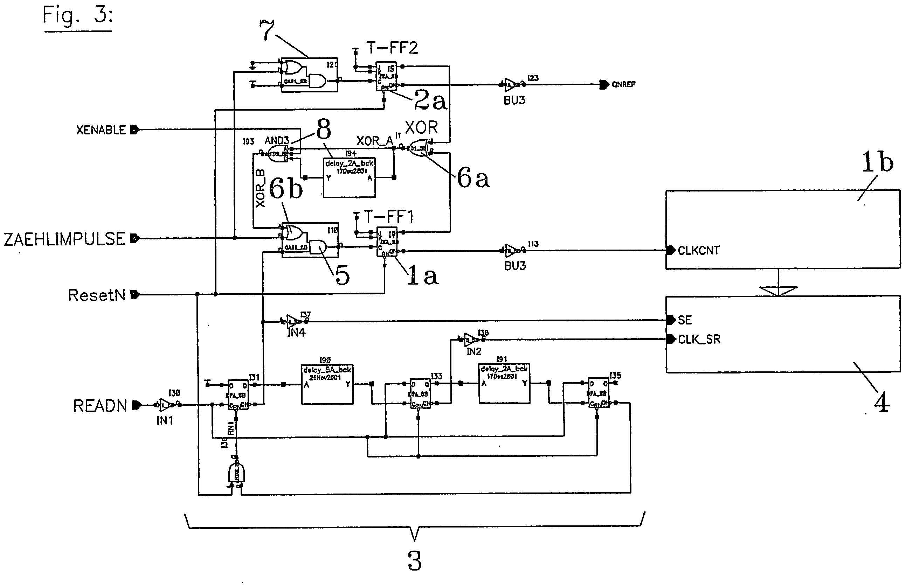

Fig. 3 zeigt ein Beispiel für eine praktische Realisierung der Ausführung der Fig. 2 als monolithisch integrierte Schaltung. Bei der praktischen Auslegung ist darauf zu achten, dass die Signallaufzeiten in den beiden parallelen Zählersegmenten 1a, 2a des Haupt- und des Referenzzählers möglichst gleich sind. Das ist in integrierten Schaltungen mit guter Näherung erreichbar, wenn auf identische Signalpfade und Ausgangslasten sowie identisches Lay-out geachtet wird.

In der Figur 3 besteht der Hauptzähler 1 aus einem Abschnitt 1b mit den höherwertigen Bits und dem 1 Bit umfassenden ersten Zählersegment 1a, das als T-Flip-Flop ausgebildet ist. Die Lesesteuerung 3 wird durch die im linken unteren Teil dargestellte Schaltung aus drei Flip-Flops und Delayelementen gebildet. Bei Vorhandensein eines schnellen Hilfstaktes könnte diese selbstverständlich auch anders realisiert werden. Innerhalb der Vergleichs- und Korrektureinrichtung 6, die auch in diesem Beispiel ein XOR-Glied 6a sowie ein OR-Glied 6b beinhaltet, ist eine Kombination aus einem AND3-Glied und einem Delay vorgesehen, die als Filter 8 gegen Spikes dient. Zur Sicherstellung annähernd gleicher Signallaufzeiten der Zählimpulse zum ersten Zählersegment 1a des Hauptzählers 1 und zum zweiten Zählersegment 2a des Referenzzählers ist vor dem Clock-Eingang des zweiten Zählersegments 2a ein OR_AND-Glied 7 vorgesehen, das nur die Funktion hat, die gleiche Signallaufzeit zu verursachen, wie das äquivalente Gatter 5/6a vor dem ersten Zählersegment 1a.

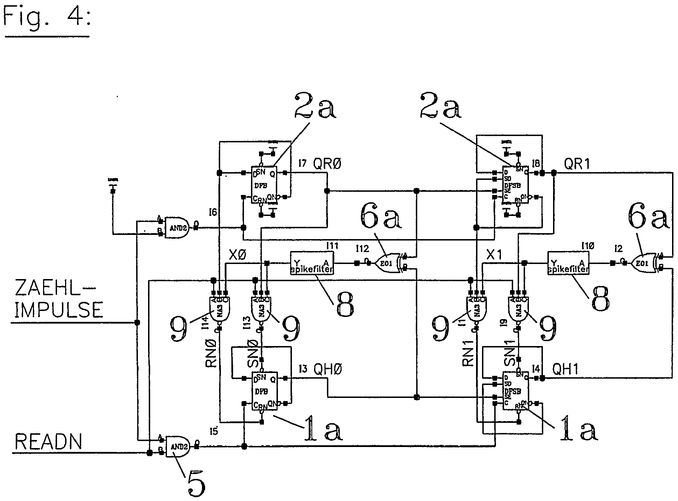

Fig. 4 zeigt schließlich den relevanten Teil eines weiteren Schaltungsbeispiels zur Realisierung des vorliegenden digitalen Zählers. In diesem Beispiel werden die Zählersegmente 1a und 2a so gewählt, dass sie zwei Bit umfassen. Bit 0 und Bit 1 der beiden Zählersegmente 1a, 2a werden jeweils von einem Komparator 6a mit nachgeschaltetem Spike-Filter 8 verglichen. Eine Differenz zwischen dem jeweiligen Haupt- und Referenz-Bit gibt zwei NAND3-Gatter 9 frei. Je nach dem, ob das Referenz-Bit High oder Low ist, wird das mit Set oder Reset (des Haupt-Bits) verbundene NAND3 aktiviert (enable). Wird READN deaktiviert (also High), so wird über die Set- und Reset-Eingänge der Hauptzähler auf den (korrekten) Wert des Referenzzählers synchronisiert. Set und Reset der Flip-Flops 1a dominieren dabei gegenüber den Takteingängen der Flip-Flops (set and/or reset override the clock). Das Spike-Filter 8 verhindert, dass kleine Schaltzeitunterschiede zwischen Referenz- und Hauptzähler zum unkontrollierten Flackern der Flip-Flops der Zählersegmente führen. Sofern der Auslesevorgang länger dauert, kann dieses Prinzip auf beliebig viele Bits in den ersten und zweiten Zählersegmenten 1a, 2a ausgedehnt werden.

### BEZUGSZEICHENLISTE

| | |
|---|---|
| 1 | Erste Zähleinrichtung (Hauptzähler) |
| 1a | Erstes Zählersegment |
| 1b | Zählersegment mit höherwertigen Bits |
| 2 | Zweite Zähleinrichtung (Referenzzähler) |
| 2a | Zweites Zählersegment |
| 3 | Lesesteuerung |
| 4 | Leseregister |
| 5 | Tor |
| 6 | Vergleichs- und Korrektureinrichtung |
| 6a | Komparator (XOR) |
| 6b | OR-Glied |
| 7 | OR_AND-Glied |
| 8 | Spikes-Filter |
| 9 | NAND3-Gatter |
| K | Signalleitung |

## Patentansprüche

1. Digitaler Zähler, der eine digitale erste Zähleinrichtung (1) mit einem ersten Zählersegment (1a) für ein oder mehrere niederwertigste Bits und eine Ausleseeinrichtung (3, 4, 5) zum Auslesen eines Zählerstandes der ersten Zähleinrichtung (1) sowie zum Unterbrechen einer Zählbereitschaft der ersten Zähleinrichtung (1) oder zum Sperren des Zugangs von Zählimpulsen zur ersten Zähleinrichtung (1) während eines Auslesevorgangs aufweist,
wobei der Zähler eine digitale zweite Zähleinrichtung (2) mit einem zweiten Zählersegment (2a) für eine gleiche Anzahl von Bits wie das erste Zählersegment (1a), die zur gleichzeitigen Erfassung der Zählimpulse parallel zur ersten Zähleinrichtung (1) angeordnet ist, sowie eine Vergleichs- und Korrektureinrichtung (6) zum Vergleich der Zählersegmentstände des ersten (1a) und des zweiten Zählersegmentes (2a) nach dem Auslesevorgang aufweist,
**dadurch gekennzeichnet,**
**dass** die Vergleichs- und Korrektureinrichtung (6) so ausgebildet ist, dass sie eine Korrektur des Zählerstandes der ersten Zähleinrichtung (1) mit einem Unterschiedswert der Zählersegmentstände durchführt.

2. Digitaler Zähler nach Anspruch 1,
**dadurch gekennzeichnet,**
**dass** die Ausleseeinrichtung (3, 4, 5), die erste (1) und zweite Zähleinrichtung (2) und die Vergleichs- und Korrektureinrichtung (6) derart aufgebaut sind, dass Laufzeiten der Zählimpulse zum ersten (1a) und zweiten Zählersegment (2a) zumindest annähernd gleich sind.

3. Digitaler Zähler nach Anspruch 1 oder 2,
**dadurch gekennzeichnet,**
**dass** die Ausleseeinrichtung (3, 4, 5), die erste (1) und zweite Zähleinrichtung (2) und die Vergleichs- und Korrektureinrichtung (6) als integrierte Schaltung ausgeführt sind.

4. Digitaler Zähler nach einem der Ansprüche 1 bis 3,
**dadurch gekennzeichnet,**
**dass** das erste (1a) und zweite Zählersegment (2a) jeweils 1 Bit umfassen.

5. Digitaler Zähler nach einem der Ansprüche 1 bis 3,
**dadurch gekennzeichnet,**
**dass** das erste (1a) und zweite Zählersegment (2a) jeweils 2 Bit umfassen.

6. Digitaler Zähler nach Anspruch 4,
**dadurch gekennzeichnet,**
**dass** die Zählersegmente (la, 2a) aus Flip-Flops in Toggle-Funktion gebildet sind.

7. Digitaler Zähler nach einem der Ansprüche 1 bis 6,
**dadurch gekennzeichnet,**
**dass** die Vergleichs- und Korrektureinrichtung (6) einen Komparator (6a) umfasst.

8. Digitaler Zähler nach einem der Ansprüche 1 bis 6,
**dadurch gekennzeichnet,**
**dass** die Vergleichs- und Korrektureinrichtung (6) einen Komparator (6a) mit nachgeschaltetem Spikes-Filter (8) umfasst.

9. Verfahren zum Zählen von Zählimpulsen, bei dem die Zählimpulse mit einem digitalen Zähler erfasst werden, der eine digitale erste Zähleinrichtung (1) mit einem ersten Zählersegment (1a) für ein oder mehrere niederwertigste Bits umfasst, und bei dem während eines Auslesevorganges des Zählers die Zählbereitschaft der ersten Zähleinrichtung (1) unterbrochen oder der Zugang der Zählimpulse zur ersten Zähleinrichtung (1) gesperrt wird,
wobei die Zählimpulse gleichzeitig mit einer digitalen zweiten Zähleinrichtung (2) erfasst werden, die ein zweites Zählersegment (2a) für die gleiche Anzahl von Bits wie das erste Zählersegment (1a) umfasst und nach dem Auslesevorgang die Zählersegmentstände des ersten (1a) und zweiten Zählersegments (2a) verglichen werden,
**dadurch gekennzeichnet,**
**dass** bei einer Abweichung der Zählerstand der ersten Zähleinrichtung (1) mit einem Unterschiedswert der Zählersegmentstände korrigiert wird.

## Claims

1. A digital counter, which has a first digital counting device (1) with a first counter segment (1a) for one or a plurality of least significant bits, and a readout device (3, 4, 5) for the readout of a counter state of the first counting device (1) , and also for the interruption of a counting readiness of the first counting device (1), or for the blocking of the access of counting pulses to the first counting device (1) during a readout procedure, wherein
the counter has a second digital counting device (2) with a second counter segment (2a) for the same number of bits as the first counter segment (1a), which second digital counting device (2) is arranged for the simultaneous recording of the counting pulses in parallel to the first counting device (1), and also has a comparison and correction device (6) for the comparison of the counter segment states of the first (1a) and the second counter segment (2a) after the reading procedure,
**characterised in that**,
the comparison and correction device (6) is designed such that it executes a correction of the counter state of the first counting device (1) with a counter segment states difference value.

2. The digital counter in accordance with Claim 1,
**characterised in that**,
the readout device (3, 4, 5), the first (1) and second counting device (2), and the comparison and correction device (6), are constructed such that transit times of the counting pulses to the first (1a) and second counter segment (2a) are at least approximately equal.

3. The digital counter in accordance with Claim 1 or 2,
**characterised in that**,
the readout device (3, 4, 5), the first (1) and second (2) counting device, and the comparison and correction device (6), are embodied as an integrated circuit.

4. The digital counter in accordance with one of the Claims 1 to 3,
**characterised in that**,
the first (1a) and second counter segment (2a) in each case comprise 1 bit.

5. The digital counter in accordance with one of the Claims 1 to 3,
**characterised in that**,
the first (1a) and second counter segment (2a) in each case comprise 2 bits.

6. The digital counter in accordance with Claim 4,
**characterised in that**,
the counter segments (1a, 2a) are formed from flip-flops in a toggle function.

7. The digital counter in accordance with one of the Claims 1 to 6,
**characterised in that**,
the comparison and correction device (6) comprises a comparator (6a).

8. The digital counter in accordance with one of the Claims 1 to 6,
**characterised in that**,
the comparison and correction device (6) comprises a comparator (6a) with a downstream spikes filter (8).

9. A method for the counting of counting pulses, in which the counting pulses are recorded with a digital counter, which comprises a first digital counting device (1) with a first counter segment (1a) for one or a plurality of least significant bits, and in which, during a readout procedure of the counter, the counting readiness of the first counting device (1) is interrupted, or the access of the counting pulses to the first counting device (1) is blocked, wherein
the counting pulses are simultaneously recorded with a second digital counting device (2), which comprises a second counter segment (2a) for the same number of bits as the first counter segment (1a), and after the readout procedure the counter segment states of the first (1a) and second counter segments (2a) are compared,
**characterised in that**,
in the event of a discrepancy, the counter state of the first counting device (1) is corrected with a counter segment states difference value.

## Revendications

1. Compteur numérique, qui présente un premier dispositif de comptage numérique (1) avec un premier segment de compteur (1a) pour un ou plusieurs bits de très faible valeur et un dispositif de lecture (3, 4, 5) pour la lecture d'un relevé de compteur du premier dispositif de comptage (1) et pour l'interruption d'un état de disponibilité de comptage du premier dispositif de comptage (1) ou pour le blocage de l'accès d'impulsions de comptage au premier dispositif de comptage (1) pendant une opération de lecture,
le compteur présentant un second dispositif de comptage (2) numérique doté d'un second segment de compteur (2a) pour un nombre de bits identique au premier segment de compteur (1a), qui est disposé pour l'enregistrement simultané des impulsions de comptage parallèlement au premier dispositif de comptage (1), ainsi qu'un dispositif de comparaison et de correction (6) pour la comparaison des relevés de segment de compteur du premier segment de compteur (1a) et du second segment de compteur (2a) après l'opération de lecture,
**caractérisé en ce que** le dispositif de comparaison et de correction (6) est conçu de telle sorte qu'il effectue une correction du relevé de compteur du premier dispositif de comptage (1) avec une valeur de différence des relevés de segment de compteur.

2. Compteur numérique selon la revendication 1,
**caractérisé en ce que**
le dispositif de lecture (3, 4, 5), le premier dispositif de comptage (1) et le second dispositif de comptage (2) et le dispositif de comparaison et de correction (6) sont conçus de telle sorte que des temps de passage des impulsions de comptage par rapport au premier segment de compteur (1a) et au second segment de compteur (2a) sont moins au moins approximativement identiques.

3. Compteur numérique selon la revendication 1 ou 2,
**caractérisé en ce que**
le dispositif de lecture (3, 4, 5), le premier dispositif de comptage (1) et le second dispositif de comptage (2) et le dispositif de comparaison et de correction (6) sont conçus sous forme de circuit intégré.

4. Compteur numérique selon l'une des revendications 1 à 3,
**caractérisé en ce que**
le premier segment de compteur (1a) et le second segment de compteur (2a) comprennent chacun un bit.

5. Compteur numérique selon l'une des revendications 1 à 3,
**caractérisé en ce que**
le premier segment de compteur (1a) et le second segment de compteur (2a) présentent chacun 2 bits.

6. Compteur numérique selon la revendication 4,
**caractérisé en ce que**
les segments de compteur (la, 2a) sont formés de flip-flops dans la fonction toggle.

7. Compteur numérique selon l'une des revendications 1 à 6,
**caractérisé en ce que**
le dispositif de comparaison et de correction (6) comprend un comparateur (6a).

8. Compteur numérique selon l'une des revendications 1 à 6,
**caractérisé en ce que**
le dispositif de comparaison et de correction (6) comprend un comparateur (6a) avec filtre de spikes (8) monté en aval.

9. Procédé pour compter des impulsions de comptage, dans lequel les impulsions de comptage sont enregistrées avec un compteur numérique, lequel comprend un premier dispositif de comptage (1) numérique avec un premier segment de compteur (1a) pour un ou plusieurs bits de très faible valeur, et dans lequel, pendant une opération de lecture du compteur, l'état de disponibilité de comptage du premier dispositif de comptage (1) est interrompu ou bien l'accès des impulsions de comptage au premier dispositif de comptage (1) est bloqué, les impulsions de comptage étant enregistrées simultanément avec un second dispositif de comptage (2) numérique, lequel comprend un second segment de compteur (2a) pour le nombre de bits identique au premier segment de compteur (1a) et les états du premier segment de compteur (1a) et du second segment de compteur (2a) sont comparés après l'opération de lecture,
**caractérisé en ce que**,
dans le cas d'un écart, l'état de compteur du premier dispositif de comptage (1) est corrigé avec une valeur de différence des relevés du segment de compteur.
